# EUROPÄISCHE PATENTSCHRIFT

(11) **EP 0 607 786 B1**
(45) Veröffentlichungstag und Bekanntmachung des Hinweises auf die Patenterteilung: **20.10.1999**
(21) Anmeldenummer: 94100037.4
(22) Anmeldetag: 04.01.1994
(51) Int. Cl.: C23C 14/34, C23C 16/00

(54) **Vorrichtung zum Beschichten von Substraten**
Apparatus for coating substrates
Appareillage pour le revêtement de substrats

(30) Priorität: 19.01.1993 DE 4301189
(43) Veröffentlichungstag der Anmeldung: 27.07.1994
(73) Patentinhaber: Balzers und Leybold Deutschland Holding Aktiengesellschaft, 63450 Hanau (DE)
(72) Erfinder: Arnold, Manfred, D-88074 Meckenbeuren (DE); Blang, Guido, D-64569 Nauheim (DE); Gegenwart, Rainer, D-63322 Rödermark (DE); Michael, Klaus, D-63571 Gelnhausen (DE); Scherer, Michael, D-63517 Rodenbach (DE); Ritter, Jochen, D-35321 Laubach (DE); Burkhardt, Oliver, D-63450 Hanau (DE)
(74) Vertreter: Schickedanz, Willi, Dipl.-Ing.

(56) Entgegenhaltungen:
- EP-A- 0 302 167
- EP-A- 0 304 895
- EP-A- 0 347 567
- US-A- 3 461 054
- US-A- 5 135 634

## Beschreibung

Die Erfindung betrifft eine Vorrichtung zum Beschichten von Substraten nach dem Oberbegriff des Patentanspruchs 1.

Bei zahlreichen Ätz- und Beschichtungsprozessen werden Plasmen erzeugt, aus denen Ionen auf ein Substrat hin beschleunigt werden. Um die Dicke einer Beschichtung oder die Tiefe einer Ätzung steuern zu können, ist eine Gleichspannung zwischen zwei Elektroden vorgesehen, die ein Plasma einschließen.

Sollen elektrisch nicht leitende Schichten auf einem Substrat aufgebracht werden, so muß anstelle einer Gleichspannung eine Wechselspannung angelegt werden, um ein Gleichstrompotential am Substrat aufzubauen, das für die Beschleunigung von geladenen Teilchen, insbesondere von Ionen, in Richtung auf das Substrat erforderlich ist.

Wesentlich für den Beschichtungs- oder Ätzeffekt ist die Ausbildung eines stationären Potentialunterschieds zwischen Plasma und Elektrode, der bei einer an der Elektrode anliegenden HF-Spannung dadurch erreicht wird, daß während der positiven Halbperiode wesentlich mehr Elektronen in die Elektrodenoberfläche als während der negativen Halbperiode positive Ionen entströmen können. Da aber im zeitlichen Mittel gleich viele positive und negative Ladungsträger aus dem Plasma abgeführt werden, lädt sich die Elektrode so weit negativ gegen das Plasma auf, bis nahezu während der ganzen Periodendauer positive Ionen einströmen können. Vor den Elektroden entstehen positive Raumladungsgebiete, die zu einem Gleichrichtereffekt und zur Ausbildung einer Sperrschichtkapazität führen (vgl. DE-PS 37 08 717, Spalte 5, Zeile 20 bis Spalte 6, Zeile 6).

Es ist bereits bekannt, beim Kathodensputtern bzw. beim reaktiven Sputtern von dielektrischen Oxiden der zwischen zwei Elektroden anliegenden Gleichspannung eine Wechselspannung zu überlagern (US-PS 3 461 054). Oberhalb der Kathode und unterhalb der Anode ist hierbei eine Sputterblende vorgesehen, während sich das zu bearbeitende Substrat auf der Anode befindet. Mit einer solchen Einrichtung ist es wegen der Anordnung des Substrats auf einer ortsfesten Anode nicht möglich, den Sputtervorgang aufrechtzuerhalten, wenn sich das Substrat bewegt, d. h. wenn es sich um eine dynamische Beschichtung bei In-Line-Systemen handelt.

Entsprechendes gilt für weitere bekannte Wechselstromzuführungen an Elektroden, die einen Plasmaraum einschließen (US-PS 4 874 494, US-PS 4 719 154, US-PS 4 424 101, US-PS 3 767 551, US-PS 3 617 459, US-PS 4 572 842; F. Vratny: Deposition of Tantalum and Tantalum Oxide by Superimposed RF and D-C Sputtering, J. Electrochem. Soc., Vol. 114, No. 5, May 1967, S. 506, Fig. 1; EP-A-0 347 567; K. Köhler, J. W. Coburn, D. E. Horne, E. Kay: Plasma potentials of 13.56 MHz rf argon glow discharges in a planar system, J. Appl. Phys. 51(1), Januar 1985, S. 59 - 66).

Es ist auch eine hochfrequenzbetriebene Sputtervorrichtung bekannt, die eine flache und als Substratträger ausgebildete Anode und eine gegenüber dieser Anode angeordnete flache Kathode aufweist (DE-OS 21 02 353). Außerdem weist diese Vorrichtung eine Antikathode auf, die aus dem Material besteht, das auf ein Substrat niedergeschlagen werden soll, wobei diese Antikathode auf derjenigen Seite angeordnet ist, die der Kathode zugewandt ist. Für die Bearbeitung von Substraten im In-Line-Betrieb ist diese Vorrichtung ebenfalls nicht geeignet.

Weiterhin ist eine Vorrichtung bekannt, in der zu beschichtende Substrate innerhalb eines Rezipienten bewegt werden (DE-OS 29 09 804). Die Hochfrequenzspannung für die Erzeugung eines Plasmas wird hierbei über Leitungen an einen Substrathalter und an einen Targethalter gelegt. Einzelheiten über die Anordnung und Halterung des Substrats sind nicht gezeigt.

Es ist ferner eine Vorrichtung zum schonenden Beschichten elektrisch leitender Gegenstände mittels Plasmas bekannt, bei der eine Abschirmung hinter einem Target vorgesehen ist, das an einer elektrischen Spannung liegt (DE-OS 37 00 633). Hierbei handelt es sich jedoch um einen Parallelplattenreaktor, bei dem keine stabile Einkopplung von HF-Energie in einen Carrier möglich ist; es würden vielmehr Nebenplasmen zünden.

Um bei einer dynamischen Beschichtung in In-Line-Systemen, bei welchen die Substrate durch ein Transportsystem während der Beschichtung an der Beschichtungsquelle vorbeigeführt werden, die Hochfrequenzspannung an die Elektroden legen zu können, wäre es denkbar, diese über einen Schleif- oder Rollenkontakt galvanisch einzukoppeln. Hierbei würden jedoch im Bereich der Spannungseinkopplung parasitäre Plasmen auftreten, die nur durch eine technisch aufwendige Dunkelraumabschirmung des Transportsystems unterdrückt werden könnten. Außerdem würden die Schleif- oder Rollenkontakte mit der Zeit beschichtet, was sich insbesondere dann, wenn die Beschichtung aus einem elektrischen Isolator besteht, negativ auf die Leistungsübertragung auswirken würde. Hinzu kommt, daß die bei der Verwendung von Schleifkontakten oder Kontaktrollen auftretende starke mechanische Belastung die Erzeugung von Partikeln fördert, die ihrerseits die Schichtqualität mindern.

Schließlich ist auch noch eine Vorrichtung zum Ätzen von Substraten durch eine Glimmentladung bekannt, bei welcher der Raum zwischen einer Elektrode und dem Substrat bzw. Substratträger bis auf einen Spalt von etwa 5 mm überbrückt ist, so daß die Glimmentladung auf den Raum zwischen Substratträger und Elektrode begrenzbar ist (DE-PS 22 41 229). Diese Vorrichtung ist jedoch ebenfalls nicht für In-line-Anlagen geeignet, weil sie einen ortsfesten Substratträger aufweist.

Der Erfindung liegt die Aufgabe zugrunde, bei einer In-line-Anlage Energie durch einen Substratträger hindurch in den Plasmaraum einzukoppeln, ohne daß dabei parasitäre Plasmen auftreten.

Diese Aufgabe wird gemäß den Merkmalen der Patentansprüche 1 und 9 gelöst.

Der mit der Erfindung erzielte Vorteil besteht insbesondere darin, eine definierte HF-Bias in ein bewegtes Substrat einer In-line-Anlage einkoppeln zu können, ohne daß dabei störende Plasmen und/oder Partikel auftreten. Durch das Vorbeiführen des Substratträgers an einer flächigen Elektrode im Dunkelraumabstand ist es möglich, HF-Leistung durch den Substratträger und die Substrate hindurch in den Plasmaraum kapazitiv einzugeben, wodurch sich ein Bias-Potential am Substrat mit gleichzeitigem Ionenbeschuß ergibt. Die Elektrodenabschirmungen werden dabei so gewählt, daß kein Plasma aus dem Plasmaraum entweichen kann. Hierdurch wird verhindert, daß im Falle eines Plasma-CVD-Prozesses sich in unkontrollierter Weise eine Schicht auf den Substraten abscheidet.

Ausführungsbeispiele der Erfindung sind in der Zeichnung dargestellt und werden im folgenden näher beschrieben. Es zeigen:
- Fig. 1: eine Sputteranlage mit einem beweglichen Substratträger, wobei zwischen zwei Elektroden ein Plasmaraum vorgesehen und eine Hochfrequenzspannung an die beiden Elektroden gelegt ist;
- Fig. 2: eine Sputteranordnung entsprechend der Anlage gemäß Fig. 1, bei der jedoch zwei einander gegenüberliegende Substrate gleichzeitig beschichtet werden können und zwischen den Elektroden ein an Spannung liegendes Schwert vorgesehen ist.

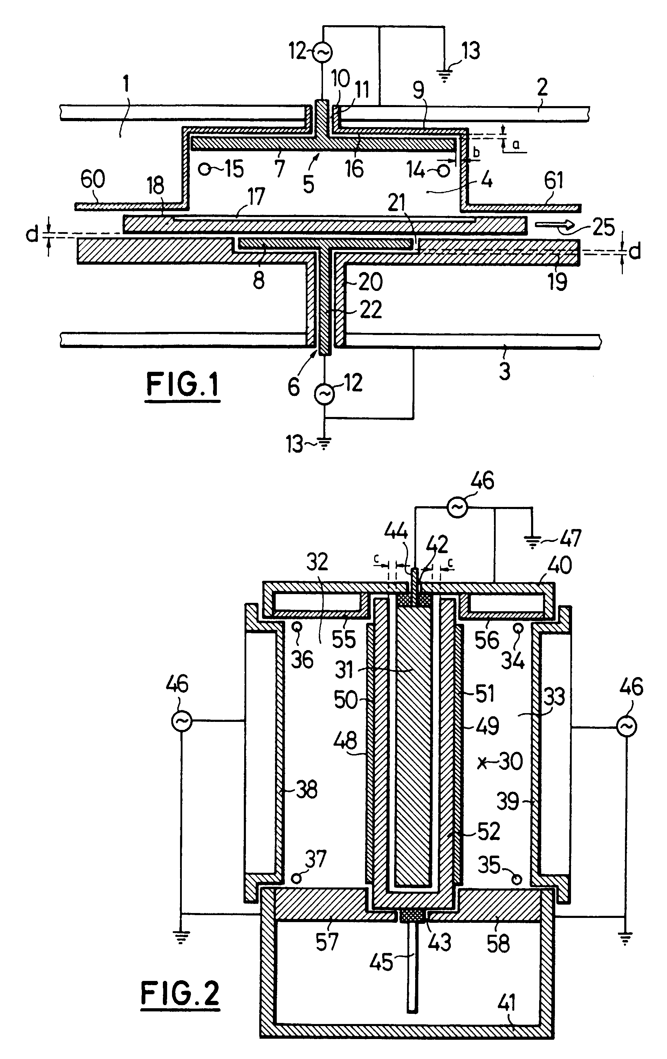

In der Fig. 1 ist schematisch eine Prozeßkammer 1 dargestellt, die durch eine obere Wand 2 und eine untere Wand 3 begrenzt ist. Zwischen den beiden Wänden 2, 3 der Prozeßkammer 1 befindet sich ein Plasmaraum 4, der eine obere Elektrode 5 und eine untere Elektrode 6 aufweist. Beide Elektroden 5, 6 sind T-förmig ausgebildet, wobei die Fläche 7 der oberen Elektrode 5 allerdings etwas größer als die Fläche 8 der unteren Elektrode 6 ist.

Die obere Elektrode 5 ist von einer topfförmigen Dunkelraumabschirmung 9 umgeben, die an ihrem Boden einen rohrförmigen Stutzen 10 aufweist, der mit seiner Außenseite an der Innenwand einer Bohrung in der Wand 2 anliegt. Durch diesen Stutzen 10 ist die Elektrode 5 mit einem senkrecht zur Fläche 7 stehenden Schenkel 11 geführt, wobei dieser Schenkel 11 an einen Anschluß einer Hochfrequenz-Wechselspannungsquelle 12 angeschlossen ist. Der andere Anschluß dieser Wechselspannungsquelle 12 liegt zusammen mit der Wand 2 an Erde 13. In der Dunkelraumabschirmung 9 und unterhalb der Fläche 7 der Elektrode 5 ist eine Gasleitung 14 bzw. 15 angeordnet, durch die Prozeßgase in den Plasmaraum 4 eingeleitet werden. Bei diesen Prozeßgasen handelt es sich beispielsweise um in He verdünntes SiH₄ und N₂O. Statt über die Gasleitungen 14, 15 kann das Prozeßgas auch durch einen Zwischenraum 16 zwischen der Elektrode 5 und der Dunkelraumabschirmung 9 in den Plasmaraum 4 eingeführt werden. Durch das dort vorhandene Plasma wird das Gas zu hochreaktiven Radikalen zersetzt, die durch Stöße vorzugsweise gegen Kammerwände etc. zum Endprodukt, z. B. SiO₂, reagieren.

Den unteren Abschluß der Plasmakammer 4 bildet ein Substrat 17, das in einen Substratträger 18 eingebettet ist. Dieser Substratträger 18 kann über eine untere Dunkelraumabschirmung 19 für die untere Elektrode 6 geführt werden. Ähnlich wie die obere Dunkelraumabschirmung 9 weist auch die untere Dunkelraumabschirmung 19 einen rohrförmigen Stutzen 20 auf, der mit seiner Außenseite an die Innenwand einer Durchbohrung in der Wand 3 stößt. Im Gegensatz zur oberen Dunkelraumabschirmung 9 ist jedoch die untere Dunkelraumabschirmung 19 nicht topfförmig ausgebildet, sondern hat die Form einer Scheibe, in der sich eine Vertiefung 21 für die Aufnahme der Fläche 8 der unteren Elektrode 6 befindet. Ein senkrecht auf dieser Fläche 8 stehender Steg 22 ist an einen Anschluß der Hochfrequenzquellen 12 angeschlossen, während die Wand 3 an Erde 13 liegt.

Das in der Plasmakammer 4 befindliche Plasma wird durch Anlegen der Spannung der Spannungsquelle 12 an die obere Elektrode 5 gezündet. Bei dieser Spannung handelt es sich vorzugsweise um eine Hochfrequenzspannung von 13,56 MHz. Um höhere Beschichtungsraten zu erzielen, können Permanentmagnete in die Elektrode eingebaut werden, wodurch sich ein RF-Magnetron-Betrieb ergibt.

Die Dunkelraumabschirmungen 9 und 19 verhindern parasitäre Plasmen an den Rückseiten der Elektroden 5 bzw. 8. Außerdem bilden sie auch die seitliche Begrenzung der Entladezone.

Das zu beschichtende Substrat 17 ist in die Aussparung des Substratträgers 18 eingelassen und kann mittels des Substratträgers an der Elektrode 5 bzw. dem Plasmaraum 4 vorbeigeführt werden. Die Bewegung des Substratträgers 18 ist durch einen Pfeil 25 angedeutet. Der Substratträger 18 kann wesentlich länger sein, als er in der Fig. 1 dargestellt ist und mehrere Substrate hintereinander tragen. Damit ist es möglich, nacheinander verschiedene Substrate zu beschichten.

Durch die Anordnung und Ausbildung der Elektroden 5, 8 wird die HF-Energie der Spannungsquelle 12 kapazitiv in den Plasmaraum 4 eingekoppelt.

Der Abstand d zwischen der unteren Elektrode 8 und dem Substratträger 18 darf den Dunkelraumabstand nicht überschreiten, damit kein parasitäres Plasma gezündet wird. Aus demselben Grund ist auch der Abstand a bzw. b der oberen Elektrode 5 zur Dunkelraumabschirmung 9 kleiner als der Dunkelraumabstand. Die Kapazität der Elektrode 5 zum Träger 18 soll möglichst groß sein, während die Masse der Elektrode möglichst klein sein soll, um am Substratträger 19 ein effizientes Gleichpotential aufbauen zu können. Der Substratträger 19 wird auch über den Bereich der Beschichtungszone hinaus im Dunkelraumabstand an Vorder- und Rückseite abgeschirmt. Damit wird einer Verschleppung der Plasmazone und der Entstehung parasitärer Plasmen entgegengewirkt. Der Substratträger 19 selbst ist so ausgeführt, daß er vom - nicht dargestellten - Transportsystem gleichstrommäßig entkoppelt bleibt, wodurch dieses Transportsystem definiert auf Masse gelegt werden kann.

In der Fig. 2 ist eine weitere Ausführungsform der kapazitiven Einkopplung von HF-Energie dargestellt. Auch hier werden Substrate z. B. in einem Sputterprozeß dynamisch, d. h. durch Vorbeibewegungen an einer Plasmaquelle, in einer In-Line-Anlage beschichtet. Die Bewegung der Substrate erfolgt hierbei in die Zeichenebene hinein, was durch das Symbol mit der Bezugszahl 30 angedeutet ist.

Die in der Fig. 2 dargestellte Vorrichtung ist gegenüber der Vorrichtung gemäß Fig. 1 um 90 Grad gekippt, d. h. die Elektroden sind jetzt nicht mehr oben und unten, sondern links und rechts. Außerdem kann mit der Vorrichtung gemäß Fig. 2 zweiseitig beschichtet werden, weil zwischen den Seitenelektroden eine Mittenelektrode vorgesehen ist.

Durch die Mittenelektrode 31 und die beiden Seitenelektroden 38, 39 werden zwei Vakuum- oder Plasmakammern 32, 33 gebildet, in denen jeweils getrennte Gaszuführungen 34, 35 bzw. 36, 37 vorgesehen sind. Oben und unten sind diese Plasmakammern 32, 33 durch U-förmige Wände 40, 41 abgeschlossen. Diese Wände 40, 41 weisen jeweils einen Schlitz 42, 43 auf, durch den ein Steg 44 bzw. 45 der Mittenelektrode 31 geführt ist. An dem Steg 44 ist der eine Anschluß einer Gleich- oder Wechselspannungsquelle 46 angeschlossen, deren anderer Anschluß am Erde 47 liegt. Die Wand 40 ist ebenfalls mit Erde 47 verbunden.

Handelt es sich bei der Spannungsquelle 46 um eine Wechselspannungsquelle, so liefert sie vorzugsweise eine Spannung von 13,56 MHz. Die Spannungsquelle 46 ist auch mit den Elektroden 38, 39 verbunden, so daß in den Räumen 32, 33 ein Plasma gezündet wird, wenn über die Einlaßrohre 34 bis 37 Edelgase eingelassen werden, die ionisiert und zu den Elektroden 38, 39 hin beschleunigt werden. Durch die hohe Energie der auftreffenden Ionen wird Material aus den Oberflächen der Elektroden 38, 39 herausgelöst, welches als Schicht auf einem Substrat 48 bzw. 49 niederschlägt. Die Substrate 48, 49 sind auf den Außenseiten 50, 51 eines U-förmigen Substratträgers 52 angeordnet, der über einen nicht dargestellten Transportmechanismus, der am Steg 45 angreift, durch die Beschichtungsanlage hindurchbewegt werden kann. Um möglichst wenig störende Fremdpartikel zu erzeugen, befindet sich der Transportmechanismus im unteren Bereich der Kammer, der durch die Wand 41 begrenzt wird. Der eigentliche Substratträger 52 ist gegen den nicht dargestellten Transporunechanismus elektrisch isoliert und am oberen Ende ohne jegliche Berührung mit einem anderen Körper. Er hat also auch keine Führungsrollen, die durch Abrieb erheblich zur Partikelkontamination beitragen würden. Zwischen den beiden Schenkeln des U-förmigen Substratträgers 52 befindet sich die Mittenelektrode 31, die einen Abstand c von den beiden Schenkeln hat, der dem Dunkelraumabstand entspricht. Die Mittenelektrode 31 dient somit als Einkoppelelektrode für den U-förmigen Substratträger 52. Zur Vermeidung von parasitären Plasmen wird der Substratträger an der Außenseite von einer geeigneten Dunkelabschirmung 55, 56 bzw. 57, 58 umgeben.

In beiden Ausführungsbeispielen ist gewährleistet, daß der Bereich, in dem ein Plasma brennen kann, auf das eigentliche Beschichtungsvolumen eingeschränkt wird. Störende parasitäre Plasmen werden wirksam unterdrückt. Außerdem wird durch die berührungslose Einkopplung der HF-Leistung vermieden, daß sich Abriebpartikel bilden. Ein weiterer Vorteil der berührungslosen, partikelfreien Einkopplung der HF-Leistung besteht darin, daß durch die flächige Leistungszuführung die Schwankungen der HF-Biasspannungen über der Substratfläche bzw. über der Substratträgerfläche wesentlich geringer sind, als im Falle der galvanischen Einkopplung, bei der die Leistung an bestimmten Kontaktstellen eingespeist wird. Hierdurch ergeben sich bessere Homogenitäten der Schichteigenschaften bzw. der Ätzverteilungen.

## Patentansprüche

1. Vorrichtung zum Beschichten von Substraten (17; 48, 49) mit *einer Prozeßkammer (1), die enthält*
1.1 eine erste flächige Elektrode (5; 38, 39), die an einem Gleich- oder Wechselstrompotential liegt;
1.2 eine zweite flächige Elektrode (6, 31), *die gegenüber der ersten flächigen Elektrode (5; 38, 39) liegt und* die an ein Gleich- oder Wechselstrompotential *angeschlossen ist;*
1.3 eine erste Abschirmung (9; 55 bis 58) für die erste flächige Elektrode (5; 38, 39);
1.4 einen Substratträger (18; 52), der einen vorgegebenen Abstand zur ersten Elektrode (5; 38, 39) aufweist,
**dadurch gekennzeichnet,** daß
1.5 der Substratträger (18; 52) zwischen den beiden flächigen Elektroden (5, 6; 31, 38; 31, 39) *und in einem Abstand von diesen* vorgesehen und parallel zu den Flächen dieser Elektroden (5, 6; 31, 38; 31, 39) bewegbar ist;
1.6 *sich die erste Abschirmung (9; 55 bis 58)* von der ersten flächigen Elektrode (5; 38, 39) bis dicht an eine Oberfläche des Substratträgers (18; 52) bzw. an eine Oberfläche des Substrats (17, 48, 49) *erstreckt, wobei diese Abschirmung (9; 55 bis 58) zusammen mit der* ersten Elektrode (5; 38, 39) und dem Substrat (17; 48, 49) einen Plasmaraum (4; 32, 33) mit Gaseinlaß (14, 15; 36, 37; 34, 35) einschließt;
1.7 die zweite flächige Elektrode (6, 31) mit einer *zweiten* Abschirmung (19) versehen ist;
1.8 die Abstände (d, c, a) der Elektroden (5; 38, 39; 6, 31) zu den Abschirmungen (9; 55 - 58, 19) *und dem Substratträger* kleiner als der Dunkelraumabstand sind.

2. Vorrichtung nach Anspruch 1, **dadurch gekennzeichnet,** daß die *erste* Abschirmung (9) topfförmig ausgebildet ist, wobei der offene Bereich auf *den Substratträger* (18) gerichtet ist.

3. Vorrichtung nach Anspruch 2, **dadurch gekennzeichnet,** daß die topfförmig *ausgebildete* erste Abschirmung (9) einen Rand (60, 61) aufweist, der dicht über dem Substratträger (18) und parallel zu dessen Oberfläche angeordnet ist.

4. Vorrichtung nach Anspruch 1, **dadurch gekennzeichnet,** daß die *zweite* Abschirmung (19) eine Platte mit einer Aussparung (21) ist, in der die *zweite* Elektrode (6) untergebracht ist.

5. Vorrichtung nach Anspruch 1, **dadurch gekennzeichnet**, daß *der Substratträger* (18) *auf seiner* Oberseite eine Aussparung aufweist, in der das Substrat (17) eingelassen ist.

6. Vorrichtung nach Anspruch 1, **dadurch gekennzeichnet,** daß durch die erste und die zweite Elektrode (5, 6) ein Plasmaraum (4) gebildet wird, in den *ein Gaseinlaß* (14, 15) *führt.*

7. Vorrichtung nach Anspruch 1, **dadurch gekennzeichnet,** daß der Gaseinlaß des Plasmaraums (4; 32, 33) ein Schlitz zwischen der Prozeßkammer (1) und dem Plasmaraum (4; 32, 33) ist, so daß das Gas von der Prozeßkammer (1) zu dem Plasmaraum (4; 32, 33) strömen kann.

8. Vorrichtung nach Anspruch 1, **dadurch gekennzeichnet,** daß die *ersten und zweiten* Abschirmungen (9, 19) jeweils *ein Verbindungsstück* (10, 20) aufweisen, *über welches ein Vorsprung* (11, 22) der *jeweiligen* Elektrode (5, 6) mit einer Spannungsquelle (12) elektrisch in Verbindung steht.

9. Vorrichtung nach Anspruch 1, **dadurch gekennzeichnet,** daß *die erste Elektrode als zwei* äußere Elektroden (38, 39) ausgebildet ist *und die zweite Elektrode* als innere Elektrode (31) ausgebildet ist, wobei die innere Elektrode (31) beidseitig vom Substratträger (52) und den beiden äußeren Elektroden umgeben ist damit zwei Plasmaräume gebildet werden, und die zweite Abschirmung entfällt.

10. Vorrichtung nach Anspruch 1, **dadurch gekennzeichnet,** daß der Substratträger (18, 52) relativ zu wenigstens einer Elektrode (6, 31) verschiebbar ist.

11. Vorrichtung nach Anspruch 9, **dadurch gekennzeichnet,** daß zwischen einer ersten äußeren Elektrode (38) und der inneren Elektrode (31) ein erstes Substrat (48) und zwischen der zweiten äußeren Elektrode (39) und der inneren Elektrode (31) ein zweites Substrat (49) vorgesehen ist.

12. Vorrichtung nach Anspruch 10, **dadurch gekennzeichnet,** daß die beiden äußeren Elektroden (38, 39) an jeweils einem ersten Anschluß einer Spannungsquelle (46) liegen, während die innere Elektrode an *einem* zweiten Anschluß dieser Spannungsquelle (46) liegt.

## Claims

1. Means for coating substrates (17; 48, 49) using *a process chamber* (1) containing the following:
a first two-dimensional electrode (5; 38, 39), attached to a DC and AC current potential;
a second two-dimensional electrode (6, 31), *positioned opposite the first two-dimensional electrode (5; 38, 39) which is connected* to a DC and AC current potential;
a first screen (9; 55 to 58) for the first two-dimensional electrode (5; 38, 39);
a substrate support (18; 52), providing a set distance to the first electrode (5;38,39)
characterised in that,
the substrate support (18; 52) is provided between the two two-dimensional electrodes (5, 6; 31, 38; 31, 39) *at a distance from these* and is moveable parallel to the surfaces of these electrodes (5, 6; 31, 38; 31, 39);
and that *the first screen (9; 55 to 58)* extends from the first electrode (5; 38, 39) up close to the surface of the substrate support (17, 48, 49), *whereby this screen (9; 55 to 58), together with the first electrode (5; 38, 39)* and the substrate (17; 48, 49) includes a plasma area (4; 32, 33) with gas inlet (14, 15; 36, 37; 34, 35);
the second two-dimensional electrode (6, 31) provides a *second screen (19);*
the distances (d, c, a) between the electrodes (5; 38, 39; 6, 31) and the screen (9; 55 - 58, 19) *and the substrate support* is smaller than the dark chamber distance.

2. Means according to claim 1, characterised in that the first screen (9) is shaped like a pot, whereby the open area is directed towards *the substrate support* **(18)***.*

3. Means according to claim 2, characterised in that the pot-shaped first screen (9) provides a rim (60, 61), which is arranged closely above the substrate support (18) and parallel to its surface.

4. Means according to claim 1, characterised in that the *second* screen (19) is a plate with a cut-out (21) which accommodates the *second* electrode (6).

5. Means according to claim 1, characterised in that the *substrate support (18)* provides a cut-out on its surface, into which the substrate (17) is set.

6. Means according to claim 1, characterised in that a plasma area (4) is formed through the first and the second electrode (5,6), into which leads *a gas inlet* (14, 15).

7. Means according to claim 1, characterised in that the gas inlet of the plasma area (4; 32, 33) is a slot between the process chamber (1) and the plasma area (4; 32, 33) which enables the gas to flow from the process chamber (1) into the plasma area (4; 32, 33).

8. Means according to claim 1, characterised in that the *first and second* screens (9, 19) each provide a *connector (10,* 20), above which a tab (11, 22) of *each respective* electrode (5, 6) is in electrical contact with a power source (12).

9. Means according to claim 1, characterised in that the first electrode is formed as two outer electrodes (38, 39) and the second electrode is formed as inner electrode (31), whereby the inner electrode (31) is surrounded on both sides by the substrate carrier (52) and both outer electrodes, so that two plasma areas are formed and the second screen becomes obsolete.

10. Means according to claim 1, characterised in that the substrate carrier (18, 52) is moveable relative to at least one electrode (6, 31).

11. Means according to claim 9, characterised in that a first substrate (48) is provided between a first outer electrode (38) and the inner electrode (31) and a second substrate (49) between the second outer electrode (39) and the inner electrode (31).

12. Means according to claim 10, characterised in that the two outer electrodes (38, 39) are connected to one first terminal of a power source (46), whereas the inner electrode is connected to a second terminal of this power source (46).

## Revendications

1. Dispositif de revêtement de substrats (17; 48, 49) avec une chambre de processus (1), contenant
1.1 une première électrode (5; 38, 39) présentant une surface, placée à un potentiel de courant continu ou alternatif;
1.2 une deuxième électrode (6, 31) présentant une surface, placée en regard de la première électrode (5; 38, 39) présentant une surface et raccordée au potentiel de courant continu ou alternatif;
1.3 un premier écrantage (9; 55 à 58) pour la première électrode (5; 38, 39);
1.4 un support à substrat (18; 52) présentant un espacement prédéterminé par rapport à la première électrode (5; 38, 39),
caractérisé en ce que
1.5 le support de substrat (18; 52) est prévu entre les deux électrodes (5, 6; 31, 38; 31, 39) présentant une surface et à distance de celles-ci et est déplaçable parallèlement aux surfaces de ces électrodes (5, 6; 31, 38; 31, 39);
1.6 le premier écrantage (9; 55 à 58), s'étend de la première électrode (5; 38, 39) présentant une surface jusqu'à proximité d'une surface du support de substrat (18; 52) et/ou d'une surface du substrat (17; 48, 49), cet écrantage (9; 55 à 58) enclosant, conjointement avec la première électrode (5; 38, 39) et le substrat (17; 48, 49), une enceinte à plasma (4; 32, 33) dotée d'une admission de gaz (14, 15; 36, 37; 34, 35);
1.7 la deuxième électrode (6; 31) présentant une surface est dotée d'un deuxième écrantage (19);
1.8 les espacements (d, c, a) des électrodes (5; 38, 39; 6, 31) vis-à-vis des écrantages (5; 51-58, 19) et du support de substrat sont inférieur à l'espacement d'espace sombre.

2. Dispositif selon la revendication 1, caractérisé en ce que le premier écrantage (9) est réalisé en forme de pot, la zone ouverte étant dirigée sur le support de substrat (18).

3. Dispositif selon la revendication 2, caractérisé en ce que le premier écrantage (9) réalisé en forme de pot présente un bord (60, 61), qui est disposé à proximité immédiate au-dessus du support de substrat (18) et parallèle à sa surface.

4. Dispositif selon la revendication 1, caractérisé en ce que le deuxième écrantage (19) est une plaque dotée d'une échancrure (21) dans laquelle est logée la deuxième électrode (6).

5. Dispositif selon la revendication 1, caractérisé en ce que le support de substrat (18) présente sur sa face supérieure une échancrure dans laquelle est inséré le substrat (17).

6. Dispositif selon la revendication 1, caractérisé en ce qu'au moyen de la première et de la deuxième électrode (5, 6) est constituée une enceinte à plasma (4) dans laquelle mène une admission de gaz (14, 15).

7. Dispositif selon la revendication 1, caractérisé en ce que l'admission de gaz de l'enceinte à plasma (4, 32, 33) est une fente ménagée entre la chambre à processus (1) et l'enceinte à plasma (4; 32, 33), si bien que le gaz peut s'écouler de la chambre à processus (1) à l'enceinte à plasma (4; 32, 33).

8. Dispositif selon la revendication 1, caractérisé en ce que les premier et les deuxième écrantages (9, 19) présentent chacun une pièce de liaison (10, 20), par l'intermédiaire de laquelle une saillie (11, 22) de l'électrode (5, 6) respective est reliée électriquement à une source de tension (12).

9. Dispositif selon la revendication 1, caractérisé en ce que la première électrode est réalisée sous la forme de deux électrodes extérieures (38, 39) et la deuxième électrode est réalisée sous la forme d'électrodes intérieures (31), l'électrode intérieure (31) étant entourée de part et d'autres par un support de substrat (52) et les deux électrodes extérieures, afin que soient constituées deux enceintes à plasma, et que le deuxième écrantage soit supprimé.

10. Dispositif selon la revendication 1, caractérisé en ce que le support de substrat (18; 52) est déplaçable par rapport à au moins une électrode (6; 31).

11. Dispositif selon la revendication 9, caractérisé en ce qu'entre une première électrode extérieure (38) et l'électrode intérieure (31) est prévu un premier substrat (48) et entre la deuxième électrode extérieure (39) et l'électrode intérieure (31) est prévu un deuxième substrat (49).

12. Dispositif selon la revendication 10, caractérisé en ce que les deux électrodes extérieures (38, 39) sont placées chacune sur un premier raccordement d'une source de tension (46), tandis que l'électrode intérieure est placée sur un deuxième raccordement de cette source de tension (46).
